# EUROPEAN PATENT APPLICATION

(11) **EP 4 815 712 A1**
(43) Date of publication of application: **30.09.2026**
(21) Application number: 26163477.8
(22) Date of filing: 10.03.2026
(51) Int. Cl.: H10W 40/47, H05K 7/20

(54) **POWER MODULE WITH HEAT SINK AND COOLING JACKET**

(30) Priority: 26.03.2025 US 202519091455
(71) Applicant: STMicroelectronics International N.V., 1228 Plan-les-Ouates, Geneva (CH)
(72) Inventor: YOO, Inpil, 82008 Unterhaching (DE); PAUL, Indrajit, 88677 Markdorf (DE); DIVAY, Valentin, 85622 Feldkirchen (DE); LEE, Tae Gyun, 81829 Munich (DE)
(74) Representative: Buzzi, Notaro & Antonielli d'Oulx S.p.A.

(57) **Abstract**

The present discussion is directed to a power module that powers and controls various electronics, such an electric motor of an electric vehicle. The device includes a cooling jacket (12) and at least one heat sink (14). The cooling jacket (12) includes at least one seat (16), an inlet channel (17), and an outlet channel (19). Each of the seats (16) includes a primary cavity (18), a secondary cavity (20), inlets, and outlets. The heat sinks (14) screw into the primary cavities (18) of the seats (16). Various circuitry and a printed circuit board are positioned on the heat sinks (14).

## Description

### BACKGROUND

### Technical Field

The present discussion is directed to power modules with cooling.

### Background

Many applications utilize power circuits or modules to power and control various electronics. For example, electric vehicles include power modules that power and control electronics for the vehicle's electric motor.

Such power modules have complex structures, such as various integrated circuits (e.g., power phase inverters, rectifiers, etc.), die interconnection structures that provide electrical connections for the integrated circuits, and source connections electrically coupled to external devices (*e.g.*, electric motors, power sources, etc.). As these structures operate at high voltages and generate substantial heat, various cooling techniques are used to regulate the temperature of the power module.

The complex structures and interconnections and cooling of these power modules demand expensive manufacturing materials and complex manufacturing steps to embed the integrated circuits and achieve electrical isolation, and often involve multiple suppliers. Consequently, the structures and interconnections of current power modules are constraints for streamlined, simple, and effective solutions for manufacturing of power modules.

### OBJECT AND SCOPE

The present discussion is directed to a device with cooling. The device is, for example, a power module that powers and controls various electronics, such an electric motor of an electric vehicle.

The device includes a cooling jacket and a plurality of heat sinks. The cooling jacket includes a plurality of seats, an inlet channel, and an outlet channel. Each of the seats includes a primary cavity, a secondary cavity, one or more inlets, and one or more outlets. Various circuitry and a printed circuit board are positioned on the heat sinks.

The heat sinks screw into the primary cavities of the seats of the cooling jacket. The heat sinks are attached to the cooling jacket without the use of adhesive, solder, or sinter. When a heat sink is screwed into a seat, coolant flows from the inlet channel, into the inlets, into the secondary cavity, out of the outlets, and to the outlet channel. The coolant physically contacts and surrounds a base portion of the heat sink in the second cavity to cool and regulate the temperature of the heat sink.

### BRIEF DESCRIPTION OF THE SEVERAL VIEWS OF THE DRAWINGS

In the drawings, identical reference numbers identify similar features or elements. The size and relative positions of features in the drawings are not necessarily drawn to scale.
Figure 1 is an angled view of a device according to an example discussed herein.
Figure 2 is a cross-sectional view along lines 2-2 of Figure 1 of a device according to an example discussed herein.
Figure 3 is an angled view of a cooling jacket according to an example discusses herein.
Figure 4 is an angled view of a heat sink according to an example discusses herein.
Figure 5 is an angled view of a device according to another example discusses herein.
Figures 6A, 6B, 6C, 6D, 6E, and 6F are subsequent operations for coupling circuitry to the exemplary device of Figure 1 according to an example discusses herein.
Figures 7A, 7B, 7C, 7D, and 7E are subsequent operations for coupling circuitry to the exemplary device of Figure 1 according to another example discusses herein.

### DETAILED DESCRIPTION

In the following description, certain specific details are set forth in order to provide a thorough understanding of various aspects of the disclosed subject matter. However, the disclosed subject matter may be practiced without these specific details. In some instances, well-known structures and methods of manufacturing electronic components, power modules, dies, and printed circuit boards (PCBs) have not been described in detail to avoid obscuring the descriptions of other aspects of the present discussion.

Unless the context requires otherwise, throughout the specification and claims that follow, the word "comprise" and variations thereof, such as "comprises" and "comprising," are to be construed in an open, inclusive sense, that is, as "including, but not limited to."

Reference throughout the specification to "one embodiment" or "an embodiment" means that a particular feature, structure, or characteristic described in connection with the embodiment is included in at least one embodiment. Thus, the appearance of the phrases "in one embodiment" or "in an embodiment" in various places throughout the specification are not necessarily all referring to the same aspect. Furthermore, the particular features, structures, or characteristics may be combined in one or more examples in any suitable manner in one or more aspects of the present discussion.

As discussed above, power modules, particularly for automotive applications, utilize power modules with complex structures and interconnections, along with various cooling techniques. Consequently, power modules typically come with specialized manufacturing processes and high costs. The present discussion provides a power module with heat sinks and a cooling jacket. The power module has a simplified design that reduces the complexity of current manufacturing processes and minimizes the associated costs.

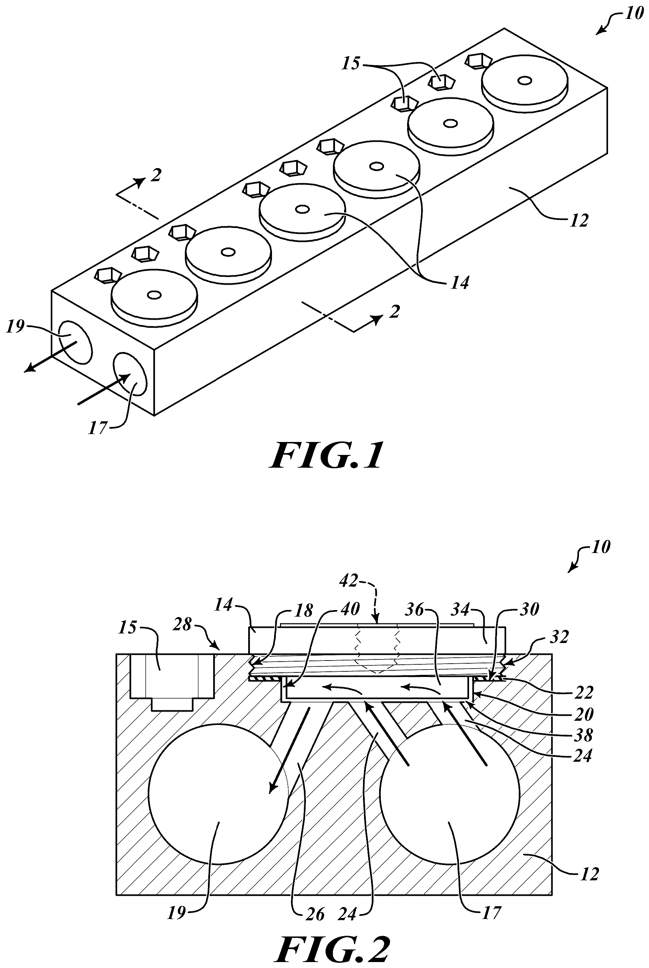

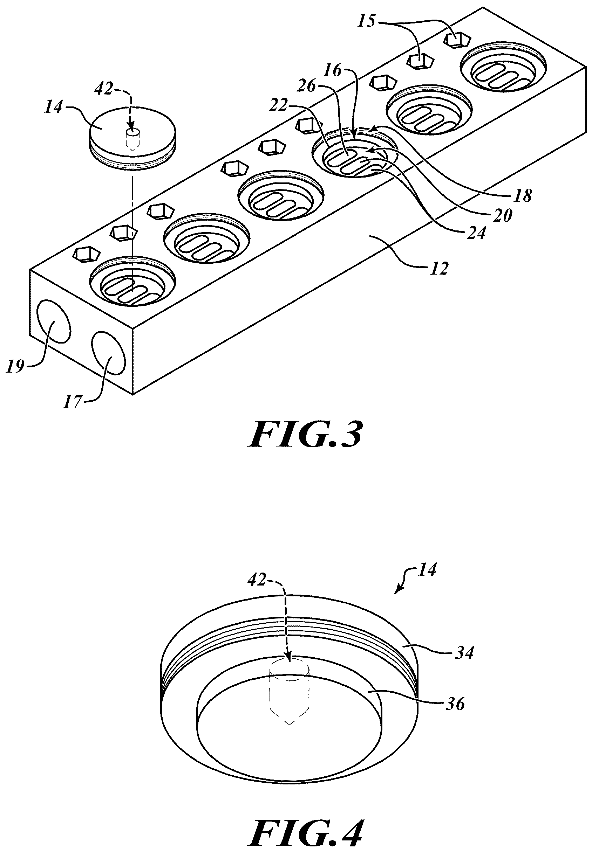

Figure 1 is an angled view of a device 10 according to an example disclosed herein. Figure 2 is a cross-sectional view of the device 10 according to an example disclosed herein. The cross-section is along axis 2-2 shown in Figure 1. Figure 3 is an angled view of a cooling jacket 12 according to an example disclosed herein.

Figure 4 is an angled view of a heat sink 14 according to an example disclosed herein. It is beneficial to review Figures 1-4 together.

The device 10 includes the cooling jacket 12 and a plurality of the heat sinks 14 for controlling the temperature of various circuitry. As will be discussed in further detail below, the circuitry, along with a printed circuit board, are positioned on the heat sinks 14. The device 10 may be used for various applications, such as power modules or packages that power and control electronics.

The cooling jacket 12 is a housing or casing for the heat sinks 14. The heat sinks 14 are inserted into, more specifically screwed into, the cooling jacket 12. The cooling jacket 12 contains a coolant, such as air, water, and oil, that physically contacts and cools the heat sinks 14.

The cooling jacket 12 includes receiving holes 15, seats 16, an inlet channel 17, and an outlet channel 19.

The receiving holes 15 are used to fasten components (e.g., a printed circuit board, an electronic component, or a physical structure) to the cooling jacket 12. A receiving hole 15 receives a fastener (e.g., screw, rivet, or bolt) that extends through the component and into the receiving hole 15. The coupling of a printed circuit board to the cooling jacket 12 will be discussed in further detail below.

The seats 16 receive and hold the heat sinks 14. Each of the heat sinks 14 is inserted and screwed into a respective one of the seats 16. While the heat sinks 14 are in the seats 16, coolant in the cooling jacket 12 physically contact the heat sinks 14. Although six seats 16 are shown in Figure 1, the cooling jacket 12 may include any number of seats. Each of the seats 16 includes a primary cavity 18, a secondary cavity 20, a sealant 22, one or more inlets 24, and one or more outlets 26.

As best shown in Figure 2, the primary cavity 18 extends into a top surface 28 of the cooling jacket 12. The primary cavity 18 has a base surface 30 and a sidewall 32. The sidewall 32 include threads that mate with threads of a coupling portion 34 of the heat sink 14 such that the heat sink 14 is able to screw into the primary cavity 18. The sidewall 32 includes female threads to mate with male threads of the heat sink 14, or vice versa. The heat sink 14 is secured to the cooling jacket 12 when screwed into the primary cavity 18.

The secondary cavity 20 extends into the base surface 30 of the primary cavity 18. The secondary cavity 20 houses a base portion 36 of the heat sink 14 as well as the coolant contained in the cooling jacket 12. The volume of the secondary cavity 20 is larger than the size of the base portion 36 such that the base portion 36 is spaced from a base surface 38 and a sidewall 40 of the secondary cavity 20. The space allows for coolant to flow from the inlet channel 17, through the inlets 24, into the secondary cavity 20, through the outlets 26, and out to the outlet channel 19. The coolant physically contacts and surrounds the base portion 36 in the second cavity 20 to cool and regulate the temperature of the heat sink 14, as well as the circuitry on the heat sink 14.

The sealant 22 is positioned on the base surface 30 of the primary cavity 18. The sealant 22 surrounds or encircles the base portion 36 of the heat sink 14. The coupling portion 34 of the heat sink 14 is on the sealant 22, and is spaced from the base surface 30 by the sealant 22. The sealant 22 keeps the coolant from leaking out of the secondary cavity 20. The sealant 22 may be any type of sealant, such as rubber or silicon.

The inlets 24 are fluidically coupled to the secondary cavity 20 and the inlet channel 17. The inlets 24 transfers coolant from the inlet channel 17 and to the secondary cavity 20. Although two inlets 24 are shown in the figures, the seats 16 may include any number of inlets.

The outlet 26 is fluidically coupled to the secondary cavity 20 and the outlet channel 19. The outlet 26 transfers coolant from the secondary cavity 20 and to the outlet channel 19. Although one outlet 26 is shown in the figures, the seats 16 may include any number of outlets.

In one example, as shown in the figures, the seat 16 includes a larger number of inlets 24 than outlets 26 in order to allow coolant to fill the secondary cavity 20.

The inlet channel 17 is fluidically coupled to the inlets 24 of the seat 16. Coolant is supplied from a coolant source to the inlet channel 17, which in turn provides the coolant to the inlets 24. The inlet channel 17 is a shared channel that is fluidically coupled to all of the inlets 24 of the seats 16.

The outlet channel 19 is fluidically coupled to the outlet 26 of the seat 16. The coolant exits from the outlet 26 to the outlet channel 19. The outlet channel 19 is a shared channel that is fluidically coupled to all of the outlets 26 of the seats 16. The coolant is then disposed of from the outlet channel 19, or cooled and returned back to the inlet channel 17.

The heat sinks 14 are inserted into the seats 16. More specifically, each of the heat sinks 14 is screwed into a respective one of the seats 16. As discussed above, the threads on the sidewall 32 of the seat 16 are mated with the threads on the coupling portion 34 of the heat sink 14. As will be discussed in further detail below, the heat sinks 14 provide platforms for various circuitry and a printed circuit board of the device 10. It is noted that no adhesive, solder, or sinter is needed. Rather, the heats inks 14 are attached simply by screwing into the seats 16.

Each of the heat sinks 14 absorbs and transfers heat away from the circuitry positioned on the heats sinks 14. The heat generated by the circuitry is transferred from the from the circuitry and to the heat sinks 14. The heat sinks 14 are then cooled by the coolant in the seats 16. As discussed above, the coolant is contained in the secondary cavities 20 of the heat sinks 14, where the coolant physically contacts the base portions 36 of the heat sinks 14.

As best shown in Figure 2, each of the heat sinks 14 includes a heat sink receiving hole 42 that is used to fasten a printed circuit board to circuitry on the heat sink 14, the heat sink 14, and the cooling jacket 12. The heat sink receiving hole 42 receives a fastener (e.g., screw, rivet, or bolt) that extends through the printed circuit board, a substrate for the circuitry (if present), and into the heat sink receiving hole 42. For example, each of the heat sink receiving hole 42 includes threads that mate with threads of the fastener. The printed circuit board includes various electrical connections or traces that are electrically coupled to the circuitry positioned on the heat sinks 14. The coupling of the printed circuit board to circuitry on the heat sinks 14, the heat sinks 14, and the cooling jacket 12 will be discussed in further detail below.

The heat sinks 14 are made of a suitable conductive metal, such as aluminum or copper. In one example, a conductive film, such as graphite film, is formed on upper surfaces of the heat sinks 14 to further increase heat spreading.

In one example, the cooling jacket 12 and the heat sinks 14 are made of two different materials. For example, in one example, the cooling jacket 12 is made of a dielectric material, such as plastic, and the heat sinks 14 are made of a conductive material, such as copper.

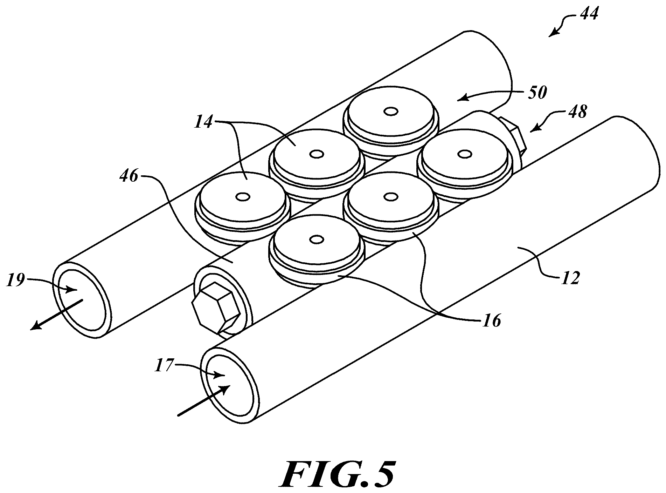

As visible in Figure 1, the device 10 includes a single row of seats 16 and corresponding heat sinks 14. However, the device 10 may include multiple rows of seats 16 and corresponding heat sinks 14 to increase the amount of circuitry in the device 10. Figure 5 is an angled view of a device 44 according to another example disclosed herein.

The device 44 is similar to the device 10. However, the device 44 includes multiple rows of seats 16 and corresponding heat sinks 14. In this example, the cooling jacket 12 includes the inlet channel 17 and the outlet channel 19, as well as a shared reservoir 46.

The shared reservoir 46 is positioned between adjacent rows of seats 16 and heat sinks 14, and is fluidically coupled to the adjacent rows of seats 16. A first row 48 of seats 16 are fluidically coupled to the shared reservoir 46 (via their outlets 26) at a first side of the shared reservoir 46, and a second row 50 of seats 16 are a fluidically coupled to the shared reservoir 46 (via their inlets 24) at a second, opposite side of the shared reservoir 46. As such, the first row 48 of seats 16 is fluidically coupled to the second row 50 of seats 16 through the shared reservoir 46. The shared reservoir 46 acts as an outlet channel for the first row 48 of seats 16, and an inlet channel for the second row 50 of seats 16.

The first row 48 of seats 16 is fluidically coupled to the inlet channel 17 (via their inlets 24), and the second row 50 of seats 16 is a fluidically coupled to the outlet channel 19 (via their outlets 26). As such, coolant flows from the inlet channel 17, into the inlets 24 of the first row 48 of seats 16, into the secondary cavities 20 of the first row 48 of seats 16, out of the outlets 26 of the first row 48 of seats 16, into the shared reservoir 46, into the inlets 24 of the second row 50 of seats 16, into the secondary cavities 20 of the second row 50 of seats, out of the outlets 26 of the second row 50 of seats 16, and into the outlet channel 19.

Although two rows of seats 16 and heat sinks 14 are shown in Figure 5, the device 44 may include any number of rows.

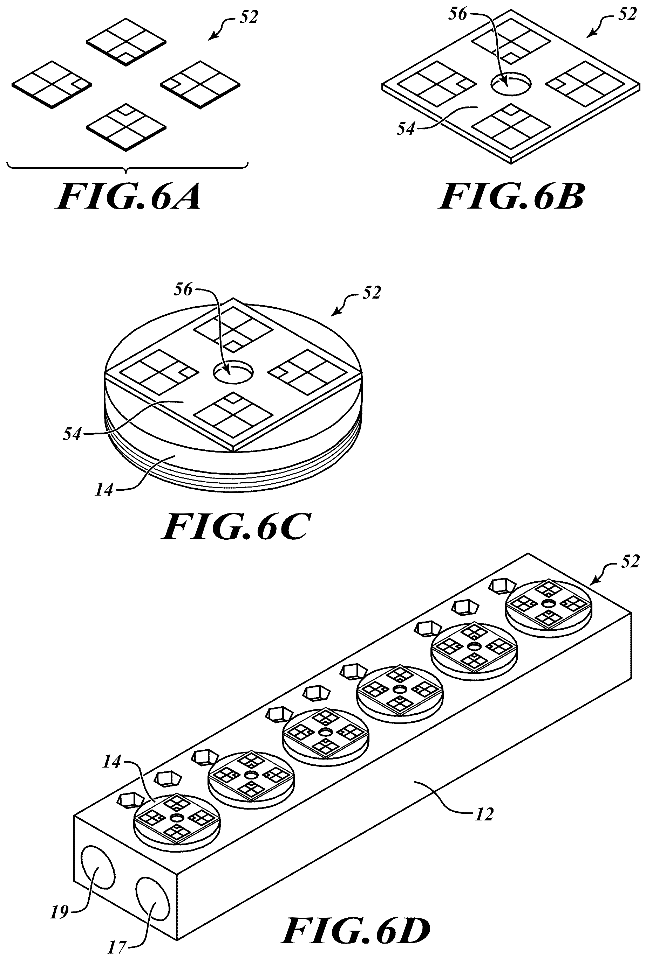

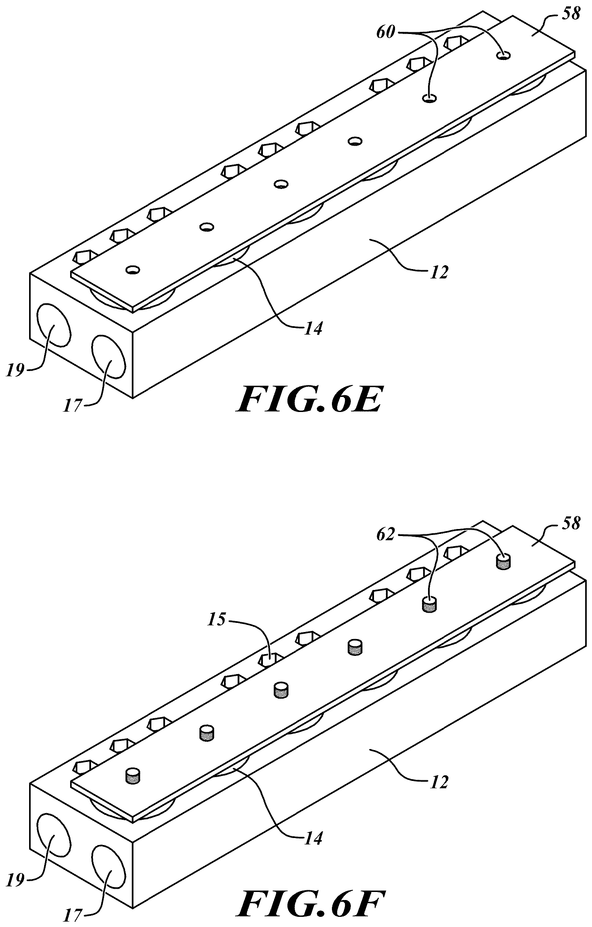

Figures 6A, 6B, 6C, 6D, 6E, and 6F are subsequent operations for coupling circuitry to the device 10 according to an example disclosed herein. In Figures 6A, 6B, 6C, 6D, 6E, and 6F, dies are electrically isolated from each other.

In Figure 6A, a plurality of dies 52 are obtained or fabricated. The dies 52 are semiconductor dies that include various integrated circuits. For example, the dies 52 include power phase inverters, rectifiers, converters, charging circuits, and other applicable semiconductor components.

In Figure 6B, the dies 52 are positioned on and attached to a substrate 54 with, for example, adhesive, solder, or sinter. The substrate 54 is a support layer that provides support for the dies 52. Multiple different materials may be used for the substrate 54. For example, the substrate 54 is a semiconductor substrate, a multilayer substrate having multiple sub-layers, or a ceramic substrate. In one example, the substrate 54 is a ceramic substrate with active metal brazing (AMB), which increases thermal conductivity of the substrate 54 and act as heat spreaders.

The substrate 54 includes a through hole 56 that extends through the entire thickness of the substrate 54. As will be discussed below, the through hole 56 allows a printed circuit board to be attached to the dies 52, the heat sinks 14, and the cooling jacket 12 by a fastener. Fasteners extend through the printed circuit board, through the through holes 56, and into the heat sink receiving holes 42 of the heat sinks 14.

In Figure 6C, the substrate 54 is positioned on and attached to the heat sink 14 with, for example, adhesive, solder, or sinter. When attached, the through hole 56 directly overlies and is aligned with the heat sink receiving hole 42 of the heat sink 14.

The steps in Figures 6A, 6B, and 6C are performed for each of the heat sinks 14. For example, with the device 10, steps in Figures 6A, 6B, and 6C are performed six times for the six heat sinks 14.

In Figure 6D, the heat sinks 14 are inserted into the seats 16, respectively, of the cooling jacket 12. As discussed above, each of the heat sinks 14 is screwed into a respective one of the seats 16. The threads on the sidewall 32 of the seat 16 are mated with the threads on the coupling portion 34 of the heat sink 14.

In Figure 6E, a printed circuit board 58 is positioned on and electrically coupled to the dies 52. The printed circuit board 58 includes electrical connections to transfer electrical signals (e.g., power signals) between the dies 52 and integrated circuits on or electrically coupled to the printed circuit board 58 and that support the dies 52 (*e.g.,* drivers, converters, and bridges on or connected to the printed circuit board 58). The printed circuit board 58 is electrically coupled to the dies 52 by, for example, connection pins that extend from the dies 52 and to the printed circuit board 58. Other techniques for electrically coupling the printed circuit board 58 to the dies 52 may also be used. A laminated bus bar may also be used instead of the printed circuit board 58.

The printed circuit board 58 includes a plurality of through holes 60 that extend through the entire thickness of the printed circuit board 58. As will be discussed in the next step, the through holes 60 allows the printed circuit board 58 to be attached to the dies 52, the heat sinks 14, and the cooling jacket 12 by fasteners. When the printed circuit board 58 is placed on the dies 52, each of the through holes 60 directly overlies and is aligned with a respective through hole 56 of a substrate 54 and heat sink receiving hole 42 of a heat sink 14.

After the printed circuit board 58 is positioned on and electrically coupled to the dies 52, underfill (*e.g*., epoxy) is dispensed on the dies 52 and the printed circuit board 58. The underfill fills any gaps between the dies 52 and the printed circuit board 58, as well as helps secure the dies 52 and the printed circuit board 58 to each other.

In Figure 6F, the printed circuit board 58 is secured to the dies 52, the heat sinks 14, and the cooling jacket 12 by fasteners 62 (*e.g.,* screws, rivets, or bolts). The fasteners 62 extend through respective through holes 60 of the printed circuit board 58, through through holes 56 of the substrate 54, and into heat sink receiving holes 42 of the heat sinks 14. In one example, the fasteners 62 are made of a conductive material, such as copper. In one example, the fasteners are made of a dielectric material, such as plastic.

In one example, the printed circuit board 58 is larger and has additional through holes 60 that directly overlie and is aligned with respective receiving holes 15 of the cooling jacket 12. In this example, the printed circuit board 58 is also secured to the cooling jacket 12 by fasteners 62 extending through the through holes 60 of the printed circuit board 58 and into the receiving holes 15 of the cooling jacket.

Coolant is then dispensed into the cooling jacket 12. As discussed above, the coolant flows through flow from the inlet channel 17, through the inlets 24, into the secondary cavities 20, through the outlets 26, and out to the outlet channel 19.

In one example, a conductive coolant, such as water, is used. The conductive coolant does not adversely affect the electrical connections of the dies 52 due to the dies 52 being electrically isolated from each other by the substrate 54.

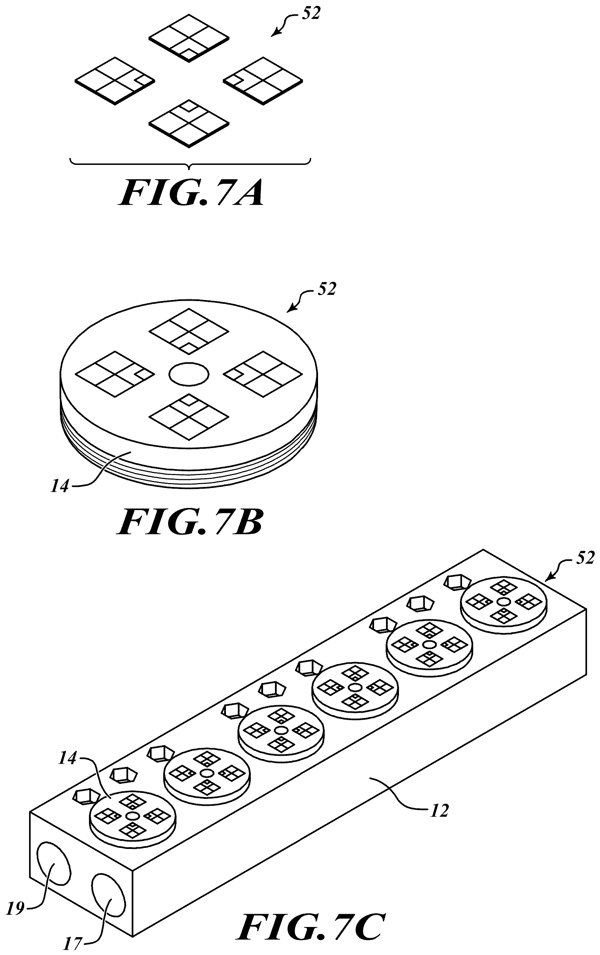

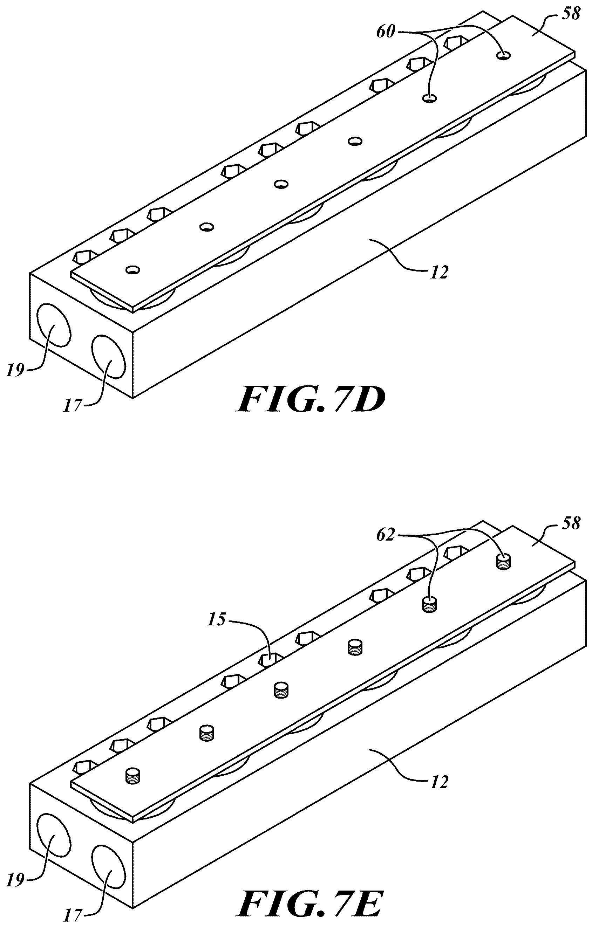

Figures 7A, 7B, 7C, 7D, and 7E are subsequent operations for coupling circuitry to the device 10 according to another example disclosed herein. In contrast to the method shown in Figures 6A, 6B, 6C, 6D, 6E, and 6F, in Figures 7A, 7B, 7C, 7D, and 7E, the dies 52 are not electrically isolated from each other by the substrate 54. Rather, the dies 52 are directly attached to the heat sinks 14, which are made of a conductive material.

In Figure 7A, the plurality of dies 52 are obtained or fabricated. As discussed above, the dies 52 are semiconductor dies that include various integrated circuits, such as power phase inverters, rectifiers, converters, charging circuits, and other applicable semiconductor components.

In Figure 7B, the dies 52 are positioned on and attached to the heat sink 14 with, for example, adhesive, solder, or sinter. The heat sink 14 is made of a suitable conductive metal, such as aluminum or copper.

The steps in Figures 7A and 7B are performed for each of the heat sinks 14. For example, with the device 10, steps in Figures 7A and 7B are performed six times for the six heat sinks 14.

The steps in Figures 7C, 7D, and 7E are substantially similar to the operations in Figures 6D, 6E, and 6F, respectively.

In Figure 7C, the heat sinks 14 are inserted into the seats 16, respectively, of the cooling jacket 12. As discussed above, each of the heat sinks 14 is screwed into a respective one of the seats 16. The threads on the sidewall 32 of the seat 16 are mated with the threads on the coupling portion 34 of the heat sink 14.

In Figure 7D, the printed circuit board 58 is positioned on and electrically coupled to the dies 52. As discussed above, the printed circuit board 58 includes a plurality of through holes 60 that extend through the entire thickness of the printed circuit board 58.

After the printed circuit board 58 is positioned on and electrically coupled to the dies 52, underfill (*e.g*., epoxy) is dispensed on the dies 52 and the printed circuit board 58. The underfill fills any gaps between the dies 52 and the printed circuit board 58, as well as helps secure the dies 52 and the printed circuit board 58 to each other.

In Figure 7E, the printed circuit board 58 is secured to the dies 52, the heat sinks 14, and the cooling jacket 12 by fasteners 62 (*e.g.,* screws, rivets, or bolts). The fasteners 62 extend through respective through holes 60 of the printed circuit board 58 and into heat sink receiving holes 42 of the heat sinks 14.

Coolant is then dispensed into the cooling jacket 12. As discussed above, the coolant flows through flow from the inlet channel 17, through the inlets 24, into the secondary cavities 20, through the outlets 26, and out to the outlet channel 19.

In one example, a dielectric coolant, such as oil, is used. The dielectric coolant ensures that dies 52 of a heat sink 14 are not inadvertently electrically coupled to dies 52 on another heat sink 14 through the heat sinks and coolant. In this example, the cooling jacket 12 is made of a dielectric material, such as plastic.

The various examples disclosed herein provide a power module with heat sinks and a cooling jacket. The heat sinks may be attached to the cooling jacket without the use of adhesive, solder, or sinter. The power module has a simplified design that reduces the complexity of current manufacturing processes and minimizes the associated costs.

A device is summarized as including a cooling jacket including: an inlet channel configured to receive a coolant; an outlet channel; and a seat; and a heat sink inserted into the seat, the seat being fluidically coupled between the inlet channel and the outlet channel such that the coolant is able to flow from the inlet channel, into the seat and contact the heat sink, and to the outlet channel.

The cooling jacket includes at least one inlet that fluidically couples the inlet channel to the seat, and at least one outlet that fluidically coupled the seat to the outlet channel.

The seat includes a first cavity extending into the cooling jacket, and a second cavity extending into a base surface of the first cavity.

The first cavity includes first threads, and the heat sink includes second threads that mate with the first threads.

The heat sink includes a coupling portion extending in the first cavity, and a base portion extending in the second cavity.

The cooling jacket includes a sealant on the base surface of the first cavity, and the coupling portion is on the sealant.

The base portion is spaced from a base surface and a sidewall of the second cavity. The cooling jacket includes another outlet channel and another seat, and the device includes another heat sink inserted into the another seat, the another seat being fluidically coupled between the outlet channel and the another outlet channel such that the coolant is able to flow from the outlet channel, into the another seat and contact the another heat sink, and to the another outlet channel.

The device further includes circuitry on the heat sink; and a printed circuit board electrically coupled to the circuitry, the printed circuit board being spaced from the heat sink by the circuitry.

The device further includes a substrate on the heat sink, the circuitry being on the substrate, the printed circuit board being spaced from the heat sink by the substrate and the circuitry.

The heat sink includes a receiving hole, and the printed circuit board is coupled to the heat sink by a fastener that is inserted into the receiving hole.

A device is summarized as including a cooling jacket including: an inlet channel; an outlet channel; and a plurality of seats fluidically coupled to the inlet channel and the outlet channel; and a plurality of heat sinks configured to screw into the plurality of seats, respectively.

A seat of the plurality of seats includes a first cavity extending into the cooling jacket, and a second cavity extending into a base surface of the first cavity.

The first cavity includes first threads, and a heat sink of the plurality of heat sinks includes second threads that mate with the first threads.

The heat sink includes a coupling portion extending in the first cavity, and a base portion extending in the second cavity.

The base portion is spaced from a base surface and a sidewall of the second cavity. A method is summarized as including positioning circuitry on a heat sink; screwing the heat sink into a seat of a cooling jacket, the cooling jacket including an inlet channel and an outlet channel, the seat being fluidically coupled to the inlet channel and the outlet channel; and coupling a printed circuit board to the heat sink, the printed circuit board being spaced from the heat sink by the circuitry, the printed circuit board being electrically coupled to the circuitry.

The method further includes providing a dielectric coolant to the inlet channel. The positioning of the circuitry on the heat sink includes: positioning the circuitry on a substrate; positioning the substrate on the heat sink, the printed circuit board being spaced from the heat sink by the substrate and the circuitry.

The method further includes providing a conductive coolant to the inlet channel.

The various examples described above can be combined to provide further examples. These and other changes can be made to the examples in light of the above-detailed description. In general, in the following claims, the terms used should not be construed to limit the claims to the specific examples disclosed in the specification and the claims, but should be construed to include all possible examples along with the full scope of equivalents to which such claims are entitled. Accordingly, the claims are not limited by the discussion.

## Claims

1. A device (10), comprising:
a cooling jacket (12) including:
an inlet channel (17) configured to receive a coolant;
an outlet channel (19); and
a seat (16); and
a heat sink (14) inserted into the seat (16),
wherein the seat is fluidically coupled between the inlet channel (17) and the outlet channel (19) such that the coolant is able to flow from the inlet channel (17), into the seat (16) and contact the heat sink (14), and to the outlet channel (19).

2. The device (10) of claim 1, wherein the cooling jacket (12) includes at least one inlet (24) that fluidically couples the inlet channel (17) to the seat (16), and at least one outlet (26) that fluidically coupled the seat (16) to the outlet channel (19).

3. The device (10) of claim 1, wherein the seat (16) includes a first cavity (18) extending into the cooling jacket (12), and a second cavity (20) extending into a base surface (30) of the first cavity (18), preferably wherein the first cavity (18) includes first threads and the heat sink (14) includes second threads that mate with the first threads.

4. The device (10) of claim 3, wherein the heat sink (14) includes a coupling portion (34) extending in the first cavity (18) and a base portion (36) extending in the second cavity (20).

5. The device (10) of claim 4, wherein:
the cooling jacket (12) includes a sealant on the base surface (30) of the first cavity (18), and the coupling portion is on the sealant, and/or
the base portion (36) is spaced from a base surface (38) and a sidewall (32) of the second cavity (20).

6. The device (10) of claim 1, wherein:
the cooling jacket (12) includes another outlet channel and another seat (48, 50), and
the device (10) includes another heat sink inserted into the another seat (48, 50),
wherein the another seat is fluidically coupled between the outlet channel (19) and
the another outlet channel such that the coolant is able to flow from the outlet channel (19) into the another seat (48, 50) and contact the another heat sink, and to the another outlet channel.

7. The device (10) of claim 1, further comprising:
circuitry (52) on the heat sink (14); and
a printed circuit board (58) electrically coupled to the circuitry (52),
wherein the printed circuit board (58) is spaced from the heat sink (14) by the circuitry (52).

8. The device (10) of claim 7, further comprising a substrate (54) on the heat sink (14), the circuitry (52) being coupled on the substrate, the printed circuit board (58) being spaced from the heat sink (14) by the substrate (54) and the circuitry (52), and/or wherein the heat sink (14) includes a receiving hole, and the printed circuit board (58) is coupled to the heat sink (14) by a fastener that is inserted into the receiving hole.

9. A device (44), comprising:
a cooling jacket (12) including:
an inlet channel (17);
an outlet channel (19); and
a plurality of seats (16, 48, 50) fluidically coupled to the inlet channel (17) and the outlet channel (19); and
a plurality of heat sinks (14) comprising heat sinks configured to screw into respective seats of the plurality of seats (16, 48, 50).

10. The device (44) of claim 9, wherein a seat (16) of the plurality of seats (16, 48, 50) includes a first cavity (18) extending into the cooling jacket (12), and a second cavity (20) extending into a base surface (30) of the first cavity (18).

11. The device (44) of claim 10, wherein:
- the first cavity (18) includes first threads, and a heat sink of the plurality of heat sinks (14) includes second threads that mate with the first threads, and/or t the heat sink (14) includes a coupling portion (34) extending in the first cavity (18), and a base portion (36) extending in the second cavity (20), preferably wherein the base portion (36) is spaced from a base surface (30) and a sidewall (32) of the second cavity (20).

12. A method, comprising:
positioning circuitry (52) on a heat sink (14);
screwing the heat sink (14) into a seat (16) of a cooling jacket (12) of the device (10; 44), the cooling jacket (12) comprising an inlet channel (17) and an outlet channel (19),
wherein the seat (16) is fluidically coupled to the inlet channel and the outlet channel; and
coupling a printed circuit board (58) to the heat sink (14),
wherein the printed circuit board is spaced from the heat sink (14) by the circuitry (52), the printed circuit board (58) being electrically coupled to the circuitry (52).

13. The method of claim 12, further comprising providing a dielectric coolant to the inlet channel (17).

14. The method of claim 13, wherein the positioning of the circuitry (52) on the heat sink (14) comprises:
positioning the circuitry (52) on a substrate (54); and
positioning the substrate (54) on the heat sink (14),
wherein the printed circuit board (58) is spaced from the heat sink (14) by the substrate (54) and the circuitry (52).

15. The method of claim 14, further comprising providing a conductive coolant to the inlet channel (17).
